# FASCICULE DE BREVET EUROPEEN

(11) **EP 0 690 506 B1**
(45) Date de publication et mention de la délivrance du brevet: **08.09.1999**
(21) Numéro de dépôt: 95201594.9
(22) Date de dépôt: 15.06.1995
(51) Int. Cl.: H01L 27/095, H01L 21/8252

(54) **Procédé de réalisation d'un dispositif semiconducteur comprenant au moins deux transistors à effet de champ ayant des tensions de pincement différentes**
Verfahren zum Herstellen einer Halbleitervorrichtung mit mindestens zwei feldeffekttransitoren verschiedener Abschnürspannung
Method of fabrication of a semiconductor device comprising at least two field-effect transistors having a different pinch-off voltage

(30) Priorité: 29.06.1994 FR 9408012
(43) Date de publication de la demande: 03.01.1996
(73) Titulaire: LABORATOIRES D'ELECTRONIQUE PHILIPS S.A.S., 94450 Limeil-Brévannes (FR); Koninklijke Philips Electronics N.V., 5621 BA Eindhoven (NL)
(72) Inventeur: Frijlink, Peter Michael, F-75008 Paris (FR); Bellaiche, Joseph, F-75008 Paris (FR)
(74) Mandataire: Lottin, Claudine

(56) Documents cités:
- EP-A- 0 469 606
- PATENT ABSTRACTS OF JAPAN vol. 9 no. 89 (E-309) [1812] ,18 Avril 1985 & JP-A-59 220927 (FUJITSU K.K.) 12 Décembre 1984,
- PATENT ABSTRACTS OF JAPAN vol. 17 no. 356 (E-1394) ,6 Juillet 1993 & JP-A-05 055268 (NEC CORP) 5 Mars 1993,
- PATENT ABSTRACTS OF JAPAN vol. 8 no. 256 (E-280) ,22 Novembre 1984 & JP-A-59 130478 (NIPPON DENKI K.K.) 27 Juillet 1984,

## Description

L'invention concerne un procédé de réalisation d'un dispositif semiconducteur intégré sur un substrat comprenant des étapes pour former au moins deux transistors à effet de champ, tous deux à canal creusé, ayant des tensions de pincement différentes.

Parmi les transistors à effet de champ ayant des tensions de pincement différentes, on trouve le transistor du type à enrichissement et le transistor du type à désertion.

Par transistor à enrichissement il faut entendre un transistor qui est bloqué en l'absence de tension grille-source (Type dit Normally-OFF ou N-OFF en anglais).

Par transistor à désertion, il faut entendre un transistor qui est passant en l'absence de tension grille-source (Type dit Normally-ON ou N-ON en anglais).

Le transistor à enrichissement a une tension de pincement plus positive que celle du transistor à désertion.

Par souci de simplicité, on désignera ci-après lesdits transistors par D pour le transistor à désertion et par E pour le transistor à enrichissement. Ces transistors sont structurellement différents en ce que l'épaisseur de la couche active sur laquelle est réalisé le contact de grille est différente pour chacun d'entre eux. Cette épaisseur est plus faible pour le transistor à enrichissement que pour le transistor à désertion.

Dans ce procédé de réalisation, l'invention s'intéresse uniquement au cas des dispositifs semiconducteurs comprenant des transistors qui, pour réaliser les deux types D et E, ont des canaux creusés. Dans ce cas, la couche active qui reçoit le contact de grille est creusée sous ce contact de grille, le contact de grille étant alors disposé dans l'évidement, de manière à régler plus précisément l'épaisseur de la couche active qui régit le fonctionnement du transistor.

L'invention trouve tout particulièrement son application dans la réalisation de dispositifs semiconducteurs intégrés incluant des transistors à hautes mobilités électroniques (en anglais, High Electron Mobility Transistor : HEMT) dont les deux types D et E sont présents sur un même substrat semiconducteur et doivent être élaborés dans le courant de la même procédure.

L'invention trouve son application, par exemple, dans la réalisation de dispositifs semiconducteurs incluant un circuit intégré dans lequel un étage amplificateur comprend un transistor de type E monté en inverseur, avec un transistor de type D comme source de courant.

L'invention trouve son application tout particulièrement dans la réalisation de dispositifs intégrés à grande échelle (LSI = Large Scale Integration en anglais) ou à très grande échelle (VLSI = Very Large Scale Integration en anglais).

Un procédé de réalisation d'un dispositif semiconducteur ayant des étapes pour fabriquer deux types de transistors à haute mobilité électronique sur un même substrat, est déjà connu de l'état de la technique par le brevet des Etats-Unis US (5 023 675 du 11 juin 1991 (Tomoroni Ishikawa-FUJITSU Limited). Ce document décrit un procédé pour réaliser sur un même substrat deux types de transistors, l'un à enrichissement, l'autre à désertion. Selon ce procédé connu, d'abord une structure de couches actives de matériaux semiconducteurs est réalisée. En relation avec les FIG.5 et 6 du document cité, cet empilement comprend, sur un substrat 21 en InP semi-isolant, une première couche 22 en InGaAs et une seconde couche 23 en InAlAs réalisant une hétérojonction pour la formation d'un gaz bidimensionnel d'électron à l'interface. Sur cet empilement de couches actives, se trouve une couche chapeau 24, formée de trois sous-couches : une couche inférieure 24a en GaAsSb dopée n, une couche intermédiaire 24b en InAlAs dopée n et une couche supérieure 24c en GaAsSb dopée n.

La couche intermédiaire 24b est prévue comme une couche d'arrêt de gravure à l'intérieur de la couche chapeau 24. Son épaisseur sera de l'ordre de 2 à 3 nm.

Ce procédé comprend ensuite des étapes pour réaliser les deux types de transistors à enrichissement et désertion, chacun à canal creusé. Pour obtenir la différence entre les deux types, la profondeur de canal creusé pour chacun d'eux est différent, d'où il résulte que la couche active disposée entre le fond du canal creusé où va se trouver le contact de grille Schottky, et l'interface où va se former le gaz bidimensionnel, a une épaisseur différente, permettant le fonctionnement soit par désertion soit par enrichissement respectivement de chacun de ces transistors.

Ces étapes comprennent d'abord le dépôt d'une couche diélectrique 25 (SiO₂), avec des ouvertures pour la réalisation des contacts ohmiques de source et drain. Cette couche diélectrique 25 est conservée tout au long du procédé.

Ensuite, une couche de photorésist 27 est déposée comme masque dans lequel l'ouverture de grille 27a du transistor à enrichissement est formée.

Puis le procédé se poursuit par des étapes de gravure pour commencer la réalisation du transistor à enrichissement :
- une première gravure de la couche diélectrique 25 à travers l'ouverture de grille 27a,
- une seconde gravure de la couche chapeau 24c jusqu'à la couche d'arrêt 24b, par RIE sélective de la couche 24c dépourvue d'In (Indium) à travers l'ouverture de grille 27a. Cette gravure RIE sélective s'arrête sur la couche 24b parce qu'elle contient de l'In (Indium). Le rapport entre le taux de RIE dans la couche chapeau 24c sans In et le taux de RIE dans la couche d'arrêt 24b avec In est de 50, en utilisant un mélange de CCl₂F₂ et de He (hélium),
- une troisième gravure sélective de la couche d'arrêt 24b en InAlAs par voie humide dans H₂SO₄, H₂O₂, H₂O.

Maintenant, le procédé est provisoirement arrêté en ce qui concerne la réalisation du transistor à enrichissement, dès que la face supérieure de la couche chapeau inférieure 24a est découverte ; alors, on commence les étapes de réalisation du transistor à désertion, qui comprennent :
- la formation de l'ouverture de grille 27b dans la couche de masque en photoresist,
- une première gravure de la couche diélectrique 25 à travers l'ouverture de grille 27b ;
- une seconde gravure sélective de la couche chapeau 24c jusqu'à la couche d'arrêt 24b, à travers l'ouverture de grille 27b, cette seconde gravure étant semblable à la seconde gravure sélective déjà menée à bien pour réaliser le transistor à enrichissement.

Durant cette seconde gravure sélective du transistor à désertion, l'élaboration du transistor à enrichissement est reprise et poursuivie par :
- une gravure sélective de la couche chapeau inférieure 24a à travers l'ouverture de grille 27a par les mêmes moyens de RIE sélective que dans la seconde étape d'élaboration de chacun des deux transistors : donc dans ce procédé la RIE sélective de la couche chapeau supérieure 24c du transistor à désertion est menée à bien en même temps que la RIE sélective de la couche chapeau inférieure 24a du transistor à enrichissement.

L'élaboration du transistor à désertion est poursuivie par :
- une troisième gravure sélective de la couche d'arrêt 24b en InAlAs, semblable à la troisième gravure sélective du transistor à enrichissement préalablement réalisée.

De sorte que, à l'issue de ces étapes de gravure sélective :
- le transistor à enrichissement a un canal creusé dont la gravure est arrêtée dès que la face supérieure de la couche active 23 est exposée,
- le transistor à désertion a un canal creusé dont la gravure est arrêtée dès que la face supérieure de la couche chapeau 24a inférieure est exposée.

Ce procédé connu comporte des inconvénients et ne permet pas de résoudre certains problèmes.

D'abord, il présente un inconvénient du fait qu'il comporte deux fois deux étapes de gravure sélective, impliquant que le choix des matériaux semiconducteurs et des agents de gravure n'est pas libre pour le concepteur de circuits intégrés.

Un but de la présente invention est de proposer un procédé plus simple.

Ensuite, il présente l'inconvénient que les transistors obtenus selon ce procédé ne sont pas réellement du type à canal creusé, puisque seulement la couche chapeau est gravée plus ou moins selon le type de transistor. Cette couche chapeau n'est pas la couche active ; elle est simplement destinée à améliorer les contacts ohmiques de source et drain, et à éloigner la couche active des perturbations mécaniques et électriques dues à la formation de l'alliage de contact ohmique. L'un des transistors conserve une partie 24a de couche chapeau dans sa structure. L'autre transistor a son contact de grille Schottky déposé directement à la surface supérieure de la couche active 23. Donc aucun des deux types de transistors ne bénéficient des améliorations de performances inhérentes à la technologie du canal creusé, technologie qui permet un ajustement beaucoup plus précis des tensions de pincement des transistors.

Le problème se pose, dans la fabrication des transistors de conception récente, de parvenir à un tel ajustement précis ; car ces nouveaux transistors ont maintenant des dimensions tellement réduites, impliquant des taux de dopage de certaines couches très élevées, qu'ils requièrent en conséquence des précisions beaucoup plus grandes sur toutes leurs cotes que cela n'était nécessaire il y encore peu de temps pour les transistors légèrement plus grands.

La solution à ce problème de précision réside dans la réalisation du transistor avec un évidement pour recevoir le contact de grille Schottky, cet évidement étant gravé plus ou moins profondément dans la couche active selon le type du transistor, de manière à ajuster précisément l'épaisseur de cette couche active, et donc à ajuster précisément la tension de pincement.

Un des buts de la présente invention est de fournir un procédé pour réaliser deux types de transistors sur la même plaquette support, ayant chacun un canal creusé respectivement à une profondeur différente, dans la couche active, de manière appropriée.

Ensuite le procédé connu présente l'inconvénient qu'il reste une partie de couche chapeau dans la structure du transistor à désertion. Il en résulte une diminution de la tension de claquage, ce qui est défavorable dans le cas des transistors de très faibles dimensions cités plus haut. De plus, dans ce cas, la grille du transistor se trouve à proximité de défauts électriques.

Un but de la présente invention est de proposer un procédé pour réaliser des transistors dont la tension de claquage est améliorée par rapport à ceux du document cité, et dont la couche chapeau joue réellement sont rôle d'éloignement des défauts.

En outre, le procédé connu présente l'inconvénient qu'il reste des parties de couche d'arrêt 24b entre les évidements de grille des deux transistors. Ces parties de couche qui sont minces, environ 2 à 3 nm, n'augmentent pas les résistances d'accès du fait du matériau InAlAs, mais elles diminuent encore la tension de claquage.

Un autre but de la présente invention est de proposer un procédé pour réaliser des transistors à canal creusé, dans la structure desquels il ne reste pas de parties de couches d'arrêt une fois terminé, de manière à éviter, selon le matériau des couches d'arrêt possible, une augmentation des résistances d'accès, la création de puits donc un effet de piégeage, ou bien des diminutions de la tension de claquage.

D'une manière générale, un but de l'invention est de fournir un procédé de réalisation sur la même plaquette support, à la fois de transistors dont l'un a une tension de pincement plus positive, ou moins négative que l'autre, par exemple à enrichissement et à désertion, avec un évidement de grille dont le fond est positionné avec une très grande précision vis-à-vis du bas de cette couche active, ou de tout autre couple de transistors ayant des tensions de pincement différentes.

Un autre problème, dans la fabrication en série de dispositifs semiconducteurs réalisés sur des plaquettes supports, réside dans le rendement de fabrication. Le rendement de fabrication est considéré comme bon si les performances des transistors sont uniformes sur toute la surface de plaquette de semiconducteur traitée (en anglais : WAFER) c'est-à-dire sont dans une fourchette de caractéristiques déterminées à l'avance. En particulier, ces performances doivent être uniformes d'un bord à l'autre de la plaquette (généralement d'un diamètre de 7,6 cm = 3") et d'une plaquette à l'autre.

Pour montrer l'importance du problème, tout à fait à titre d'exemple, on peut citer qu'un transistor à effet de champ à enrichissement présente un canal creusé sur une profondeur de l'ordre de 15 nm dans la couche active supérieure, elle-même de l'ordre de 50 nm. Ce transistor travaille entre 200 mV et 700 mV, avec une tension de pincement de l'ordre de 350 mV. Toute erreur sur la localisation du fond de l'évidement de grille crée une erreur sur la tension de pincement. Par exemple, une erreur de la hauteur d'une monocouche de matériau cristallin semiconducteur (une monocouche ayant une épaisseur de l'ordre de 0,3 nm) sur cette profondeur, entraîne une erreur de 22 mV sur la tension de pincement, puisque l'épaisseur finale de la couche canal est déterminée par la localisation du fond de l'évidement de grille par rapport au bas de la couche active creusée. Il en résulte que, pour un transistor à enrichissement ayant une fourchette de fonctionnement aussi étroite, une erreur de localisation du fond de l'évidement de grille de quelques monocouches cristallines, entraîne une terrible variation des performances électriques de ce transistor.

A titre d'exemple également, on peut citer qu'un transistor à effet de champ à désertion, présente quand à lui, un canal creusé sur une profondeur de l'ordre de 6 nm dans la couche active supérieure, c'est-à-dire ayant à peine 10 nm de différence avec l'évidement du transitor à enrichissement.

Il en résulte que, pour cette raison également, la localisation du fond des évidements de grille doit être très précise pour chaque type de transistor. Dans ce cas aussi de fabrication de deux types différents de transistors sur la même plaquette, l'erreur sur la localisation du fond des évidements de grille ne devra jamais dépasser la hauteur de quelques monocouches cristallines du matériau de la couche canal, c'est-à-dire pas plus de quelques fois 0,3 nm. D'une manière générale, cette erreur doit être la plus petite possible devant la valeur d'environ 10 nm de différence des distances caractéristiques des deux types de transistors à réaliser.

Donc un autre but de l'invention est de proposer un procédé de réalisation qui permet non seulement de réaliser le canal creusé de chaque type de transistor avec une grande précision, mais encore avec une grande uniformité sur l'ensemble d'une même plaquette support (WAFER), et d'une plaquette à l'autre.

Un procédé de réalisation des transistors qui, pour réaliser les deux types D et E, ont des canaux creusés, est connu du brevet JP-A-59 220 927 (PAJ Vol. 9 No. 89). Un autre procédé de réalisation d'un transistor ayant un canal creusé, dans lequel on forme automatiquement une couche d'arrêt de gravure en fluorure d'aluminium est déjà connu du document JP-A-5 055 268 (PAJ Vol. 17, No. 356).

Selon l'invention ces buts sont atteints, au moyen d'un procédé de réalisation d'un dispositif semiconducteur incluant au moins deux transistors à effet champ, du type à canal creusé, dont le premier a un évidement de grille moins profond que l'autre, ce procédé comprenant :
- la réalisation d'un empilement de couches sur un substrat, parmi lesquelles au moins :
   . une couche active en un composé semiconducteur incluant un taux d'aluminium non nul, dans laquelle un évidement de grille est à creuser,
   . une couche chapeau en un composé semiconducteur sans aluminium,
   . une couche de masquage munie d'une ouverture dite ouvertures de grille pour chaque transistor,
- une première gravure sélective, avec un premier agent de gravure composé du fluor pratiquée dans la couche chapeau, à travers les ouvertures de grille des deux transistors, et jusqu'à formation, à la surface supérieure de la couche active, d'une couche d'arrêt en fluorure d'aluminium, puis l'élimination de cette couche d'arrêt, et le recouvrement, au moyen d'un matériau pouvant être éliminé sans détérioration de la couche de masquage précédemment déposée, de la région du premier transistor,
- une seconde gravure non sélective pratiquée dans la couche active, à travers l'ouverture de grille jusqu'à un niveau intermédiaire de l'évidement de grille du second transistor E, à une profondeur égale à la différence des profondeurs des évidements de grille des deux transistors, et l'élimination du matériau de recouvrement,
- une troisième gravure non sélective pratiquée dans la couche active, de manière concomitante à travers les deux ouvertures de grille des deux transistors jusqu'au niveau du fond de l'évidement de grille du premier transistor.

Un avantage présenté par le procédé selon l'invention, est que l'on forme, non pas lors de la réalisation des couches semiconductrices avant toute étape de gravure, mais au contraire durant l'une des étapes de gravure elle-même, une couche d'arrêt de gravure de cette étape de gravure en cours, et que cette couche d'arrêt ainsi formée à des propriétés remarquables :
- elle se forme automatiquement pendant cette étape de gravure à une position reproductible qui est la face supérieure de la couche active, et ceci, sur l'entière surface du substrat traité,
- elle arrête automatiquement cette étape de gravure en cours à ce niveau qui sert de repère reproductible sur l'entière surface du substrat traité,
- elle se forme sous une épaisseur suffisamment grande pour arrêter l'étape de gravure en cours,
- elle se forme sous une épaisseur suffisamment faible pour être facilement éliminable sans allonger le procédé ou perturber les surfaces déjà formées.

Un autre avantage présenté par le procédé selon l'invention est que la couche d'arrêt de gravure utilisée est éliminée en cours du procédé. Cet avantage consiste plus particulièrement dans le fait que cette couche d'arrêt n'existe plus dans le transistor fini, et donc que le transistor ainsi formé, contrairement aux transistors qui contiennent encore des couches d'arrêt une fois terminés, ne voit pas ses performances perturbées par ces couches parasites : il est en effet évident que, compte tenu des dimensions submicroniques impliquées dans les transistors, à ce jour, tout élément non nécessaire, ayant même de très faibles dimensions, vient perturber le fonctionnement ; par exemple il est connu que certaines couches d'arrêt maintenues en fin de procédé introduisent des résistances parasites, ou forment des puits et produisent des effets de piégeage ; il est également connu que certaines couches d'arrêt dont la composition est au contraire capable de diminuer les résistances d'accès, ne tiennent pas en tension et produisent des claquages, particulièrement dans les transistors submicroniques actuels.

Un autre avantage présenté par le procédé selon l'invention est que les niveaux du fond des évidements de grille sont réalisés à partir d'un niveau bien défini par la couche d'arrêt. Par conséquent, ces niveaux, dont la position est très importante pour définir l'épaisseur de la couche active, est ainsi obtenu par une gravure bien contrôlée, et est lui-même bien défini. En effet, à partir du moment où la couche d'arrêt a été éliminée, l'épaisseur de matériau qui est à graver dans chaque gravure non sélective est très petite, et donc l'erreur qui peut se produire sur une telle faible profondeur gravée ne peut être qu'excessivement petite. Ainsi, la précision requise sur la position de ce niveau du fond des évidements de grille est obtenue, comme cela est de la plus haute importance puisque l'on sait que les épaisseurs enrichies ou désertées, qui sont en jeu pour bloquer ou rendre passant les transistors, sont extrêmement faibles et que toute imprécision sur l'épaisseur finale du canal résulte en des variations catastrophiques des performances des transistors finis. Les performances des transistors selon l'invention sont maintenant assurées d'être très bonnes, fiables et reproductibles dans le cours du processus de fabrication de plusieurs milliers de transistors répartis sur une grande surface.

L'invention est décrite ci-après en détail, en référence avec les figures schématiques annexées parmi lesquelles :
- la FIG.1A représente une coupe de deux transistors à effet de champ du type HEMT à canal creusé, l'un à désertion et l'autre à enrichissement, sur laquelle les différences de profondeur des évidements de grille sont indiquées ;
- et la FIG.1B représente ces deux transistors et leurs différents éléments ;
- les FIG.2A à 2E représentent les différentes étapes du procédé pour réaliser les transistors de la FIG.1B,
- la FIG.3 représente une variante avantageuse de l'empilement des couches semiconductrices pour réaliser des transistors HEMTs pseudomorphiques.

L'invention concerne un procédé de réalisation d'un dispositif semiconducteur comprenant, sur un substrat, au moins deux transistors à canal creusé, l'un référencé E d'un premier type ayant une tension de pincement plus positive, ou moins négative que l'autre, par exemple à enrichissement, c'est-à-dire normalement bloqué en l'absence de tension grille-source (en anglais, enhancement, normally-OFF transistor), l'autre référencé D, d'un second type, c'est-à-dire ayant une autre tension de pincement, par exemple à désertion, c'est-à-dire normalement passant en l'absence de tension grille-source (en anglais : depletion, normally-ON transistor).

L'invention est décrite dans l'application à la réalisation de transistors à haute mobilité électronique (en anglais : High Electron Mobility Transistor HEMT) désigné ci-après par HEMT.

Les propriétés du HEMT considéré en tant que tel sont bien connues de l'homme du métier des circuits intégrés, tant numériques qu'analogiques, en toutes technologies, et de ce fait ne sont pas décrites ici plus avant.

D'une manière générale, aussi bien le transistor HEMT à enrichissement que le transistor HEMT à désertion comprend un empilement de couches dites actives réalisées sur un substrat 1, parmi lesquelles se trouvent au moins :
- une première couche 10 en un premier matériau de faible largeur de bande interdite, faiblement dopée ;
- une seconde couche active 13 en un second matériau de plus grande largeur de bande interdite, fortement dopée de type n⁺⁺, formant une hétérostructure avec la première couche 10, d'interface 20 ;
- une troisième couche 4, fortement dopée n⁺⁺, dite couche chapeau (en anglais : CAP LAYER).

Chaque transistor HEMT à désertion D et à enrichissement E comprend respectivement :
- deux plots de contact ohmique, pour former les contacts électriques de source et drain du transistor ; ces plots sont réalisés en surface de la couche chapeau au moyen d'un alliage métal/semiconducteur ; les contacts ohmiques du transistor à désertion sont référencés 5D ; ceux du transistor à enrichissement 5E ;
- un plot métallique de grille directement déposé sur le matériau de la couche active supérieure 13 pour former une barrière Schottky ; le contact Schottky du transistor à désertion est référencé 8D, et celui du transistor à enrichissement 8E.

Cette barrière Schottky doit se trouver à une distance très précise du bas de la couche active 13, c'est-à-dire à une distance très précise de l'interface 20 de l'hétérostructure formée des couches 13/10.

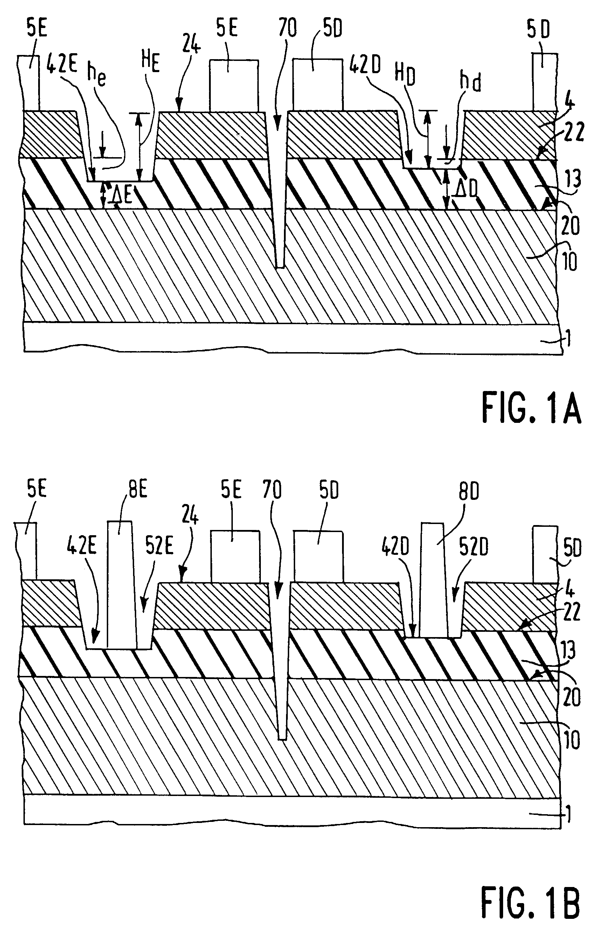

En référence avec la FIG.1B, un meilleur fonctionnement et des meilleures performances des transistors, respectivement à désertion D et à enrichissement E, sont obtenus lorsque les contacts de grille 8D et 8E sont disposés dans un évidement 52D, 52E (en anglais : RECESS) dont le fond 42D et 42E est à une distance précise ΔD, ΔE de l'interface 20 d'hétérostructure. Cette distance ΔD, ΔE représente l'épaisseur effective de la couche active 13 pour chaque type de transistor. Cette épaisseur régit le fonctionnement du transistor, qui, selon cette épaisseur est du type à enrichissement (en anglais : ENHANCEMENT, Normally-OFF transistor) ou bien du type à désertion (en anglais : DEPLETION, Normally-ON transistor).

En référence avec la FIG.1A, le transistor à effet de champ à enrichissement E présente un évidement dont le fond 42E est à une distance hE de l'ordre de 15 nm, de la face supérieure de la couche active supérieure 13, elle-même de l'ordre de 50 nm. La profondeur totale de l'évidement de grille à partir de la face supérieure de la couche chapeau est HE.

Puisque l'épaisseur finale de la couche canal est déterminée par la localisation du fond de l'évidement de grille par rapport à la position de l'interface 20 de l'hétérostructure, il en résulte que, pour un tel transistor à enrichissement, une erreur de localisation du fond de l'évidement de grille de quelques monocouches cristallines, entraîne une terrible variation de ses performances électriques.

Le transistor à effet de champ à désertion D présente un évidement dont le fond 42D est à une distance hD de l'ordre de 6 nm de la face supérieure de la couche active supérieure 13. Donc les deux types de transistor E et D se distinguent l'un de l'autre seulement par une différence de profondeur d'évidement de moins de 10 nm. La profondeur totale de l'évidement de grille à partir de la face supérieure de la couche chapeau est HD.

C'est pourquoi, dans le procédé selon l'invention, des étapes sont proposées pour réaliser une localisation extrêmement précise du fond 42D et 42E des évidements qui reçoivent les contacts de grille 8D, 8E. L'avantage du procédé selon l'invention est de permettre cette localisation sans dépasser une erreur permise de seulement quelques monocouches cristallines de matériau semiconducteur (une monocouche ayant une épaisseur de l'ordre de 0,3 nm). De plus, cette localisation est non seulement précise, mais aussi uniforme sur la totalité de la surface de la plaquette à traiter (WAFER), laquelle est généralement d'un diamètre de 7,6 cm (en pouces = 3"), et d'une plaquette à l'autre.

En référence avec la FIG.1, la structure des transistors HEMTs montre avantageusement une couche chapeau 4. Cette couche chapeau 4 a d'abord pour fonction de diminuer les résistances de source et de drain des transistors réalisés au moyen du procédé proposé par l'invention. En effet cette couche 4 fortement dopée n⁺⁺ augmente la conduction du matériau semiconducteur dans les régions situées sous les contacts ohmiques de source et drain 5D, 5E.

Cette couche chapeau 4 a aussi pour fonction d'éloigner de la région du canal, les régions sous-jacentes aux contacts ohmiques de source et drain, régions qui sont mécaniquement et électriquement perturbées lors de la fusion de l'eutectique pour former l'alliage métal-semiconducteur constituant les contacts ohmiques 5E et 5D.

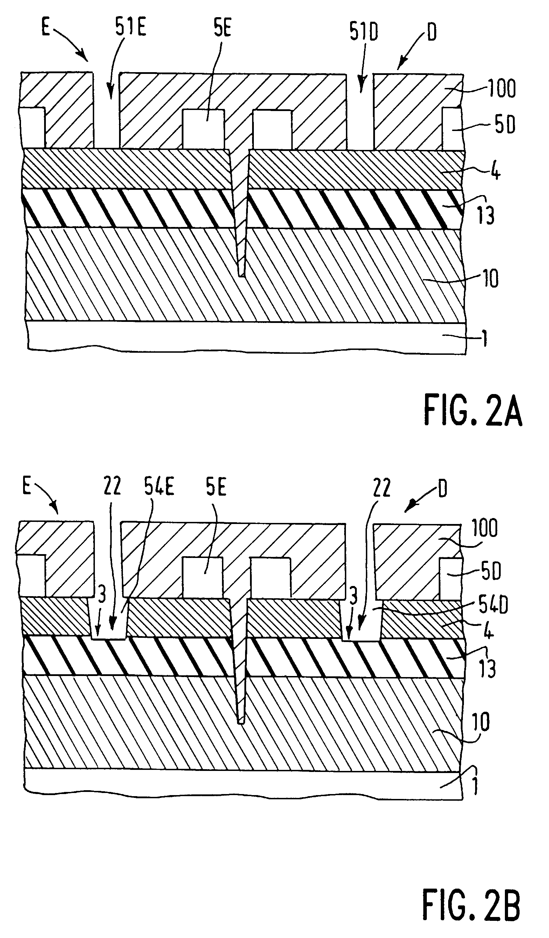

La méthode selon l'invention pour réaliser à la fois un évidement de grille, avec la précision voulue, dans chaque structure de transistors D et E est décrite ci-après en référence avec les FIG.2A à 2E.

Elle met en oeuvre la réalisation de gravures pratiquées dans l'empilement des couches, incluant, l'autoalignement de ces gravures sur les ouvertures du masque délimitant les contacts de grille.

Donc, selon cette méthode, une seule couche de masquage classique, en photorésist par exemple, est utilisée, et non deux couches l'une en diélectrique et l'autre en photorésist comme il était connu de l'état de la technique.

En référence avec la FIG.2A, le procédé comprend la formation de l'empilement des couches de matériau semiconducteur incluant au moins :
- la formation d'un substrat 1 en arséniure de gallium semi-isolant,
- la croissance d'une couche 10 en arséniure de gallium non dopée intentionnellement, d'épaisseur comprise entre 100 et 1000 nm, et de préférence d'épaisseur 400 nm, qui est la couche de faible largeur de bande interdite ;
- la croissance d'une couche 13 en arséniure de gallium et d'aluminium (GaAlAs) avec une concentration en aluminium (Al) de l'ordre de 22 %, fortement dopée de type n⁺⁺, par exemple au moyen d'espèces telles que le silicium (Si) à un taux supérieur ou égal à 10¹⁸ x cm⁻², d'épaisseur comprise entre 20 et 80 nm, et de préférence 50 nm, qui est la couche de plus grande largeur de bande interdite que la couche 10 sous-jacente.

Ces couches peuvent être réalisées par croissance épitaxiale sur le substrat semi-isolant.

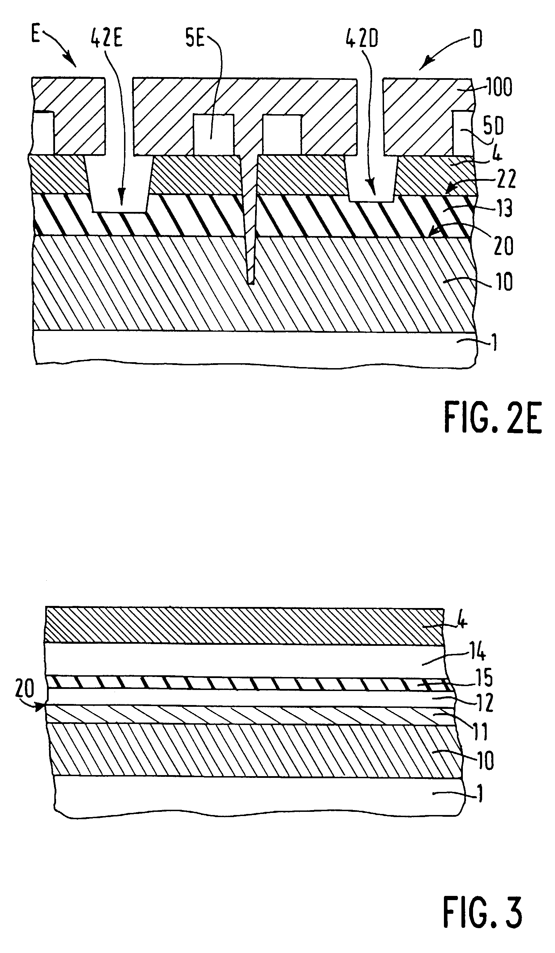

En référence avec la figure 3, dans une variante, cet empilement de couches peut comprendre, à partir du substrat 1 :
- la croissance de la couche 10 en arséniure de gallium (GaAs) non dopée intentionnellement, alors appelée couche tampon (en anglais : BUFFER), ayant les épaisseurs données plus haut pour la couche également référencée 10 ;
- la croissance d'une couche 11 en arséniure de gallium et d'indium (GaInAs), alors appelée couche canal (en anglais : CHANEL), ayant une concentration en indium de l'ordre de 22 %, non dopée intentionnellement, d'épaisseur comprise entre 0 et 30 nm, et de préférence 10 nm ;
- la croissance d'une couche 12, appelée couche espaceur (en anglais : SPACER), en arséniure de gallium et d'aluminium (GaAlAs), ayant une concentration en aluminium (Al) de l'ordre de 22 %, non dopée intentionnellement, d'épaisseur comprise entre 0 et 5 nm, et de préférence 3 nm ;
- la croissance d'une couche 15 en arséniure de gallium et d'aluminium (GaAlAs), dans ce cas appelée couche donneur (en anglais : CARRIER SUPPLYING LAYER), ayant une concentration en aluminium (Al) de l'ordre de 22 %, fortement dopée n⁺⁺ à un taux supérieur à 10¹⁸ x cm⁻², d'épaisseur comprise entre 0,3 nm (une monocouche cristalline) et 40 nm, et de préférence 25 nm ;
- la croissance d'une couche 14, en arséniure de gallium et d'aluminium (GaAlAs), de ce cas appelée couche Schottky, ayant une concentration en aluminium (Al) de l'ordre de 22 %, non dopée intentionnellement, d'épaisseur 10 à 40 nm, et de préférence 25 nm ;
- la croissance de la couche chapeau 4 (CAP LAYER), en arséniure de gallium (GaAs), fortement dopée n⁺⁺ à un taux supérieur à 10¹⁸ x cm⁻³, d'épaisseur comprise entre 5 et 100 nm, et de préférence 50 nm.

Dans cet agencement de couches, le matériau d'arséniure de gallium et d'indium (GaInAs) pour réaliser la couche canal 11 présente une faible largeur de bande interdite, alors que le matériau d'arséniure de gallium et d'aluminium (GaAlAs) pour réaliser successivement la couche espaceur non dopée 12, la couche donneur fortement dopée 15 et la couche Schottky 14, présente une plus grande largeur de bande interdite. Dans ces conditions, un gaz bidimensionnel d'électrons s'établit à l'interface 20 des couches espaceur 12/canal 11, de largeurs de bande interdite différentes. Le HEMT présentant cet agencement est connu sous le nom de transistor à haute mobilité électronique, pseudomorphique, et fournit à ce jour de meilleures performances que le HEMT à structure plus simple décrit plus haut, car dans la structure pseudomorphique, la différence entre les largeurs de bande interdite des matériaux est plus grande.

Cependant le procédé selon l'invention peut s'appliquer à la réalisation de tout transistor ayant un évidement de grille creusé dans la partie supérieure d'un empilement de couches qui comprend au moins :
- une couche supérieure 13 ou 14 sur laquelle le contact Schottky est formé dans un évidement, dont le matériau semiconducteur inclut au moins un taux d'aluminium non nul ; par taux non nul, on entend qu'une concentration en aluminium (Al) de 0,1 dans la formule du composé semiconducteur est déjà suffisante pour pouvoir mettre en oeuvre l'invention ;
- une couche chapeau 4 dont le matériau semiconducteur n'inclut pas d'aluminium.

A la suite de la réalisation de l'empilement des couches de matériaux semiconducteurs, par exemple par croissance épitaxiale, en mettant en oeuvre favorablement une technique connue de l'homme du métier telle que l'épitaxie par jet moléculaire (en anglais : MOLECULAR BEAM EPITAXY, MBE) ou le dépôt en phase vapeur aux organo-métallic (en anglais : ORGANIC CHEMICAL VAPOR DEPOSITION, MOCVD), le procédé de réalisation du transistor comprend :
- la réalisation des contacts ohmiques de source et drain 5D et 5E, par toute méthode connue de l'homme du métier.

Puis le procédé de réalisation des évidements de grille est mis en oeuvre. Ce procédé comprend spécifiquement selon l'invention :
- en référence avec la FIG.2A, la formation d'un masque 100, en photorésist, muni de deux ouvertures 51D, 51E, qui peuvent être microniques ou submicroniques et qui sont favorablement réalisées en même temps et de mêmes dimensions pour les deux types de transistors à réaliser, pour délimiter les futurs contacts de grille 8D et 8E de ces deux transistors ; toutes les ouvertures ultérieures impliquées dans ce procédé se trouveront auto-alignées sur les ouvertures de grille 51D et 51E respectivement ; ces ouvertures de grilles 51D, 51E découvrent la surface supérieure 24 de la couche chapeau 4. La réalisation des ouvertures de grille microniques ou submicroniques dans le masque 100 est mise en oeuvre par toute méthode connue de l'homme du métier, par exemple par écriture par faisceau d'électrons (en anglais : ELECTRON-BEAM) ;
- en référence avec la FIG.2B, la gravure simultanée d'ouvertures respectivement 54D et 54E pour les deux transistors, formées dans la couche chapeau 4, jusqu'à la surface supérieure 22 de la couche sous-jacente référencée 13 ou bien 14 (selon que des HEMTs ou des HEMTs pseudomorphiques sont réalisés), en matériau semiconducteur incluant l'élément aluminium (Al) ; cette gravure est mise en oeuvre par une méthode de gravure ionique réactive (en anglais RIE) avec un plasma formé d'un agent composé incluant au moins le fluor (F), avec par exemple le chlore (Cl) ; par exemple, favorablement le plasma utilisé peut inclure C₂Cl₂F₂, ou bien une association de SiCl₄ et SF₆ ; dans ces conditions, la gravure du matériau de la couche chapeau 4, qui est, dans l'exemple décrit, de l'arséniure de gallium (GaAs), est sélective vis-à-vis du matériau de la couche sous-jacente 13 ou 14, qui est, dans l'exemple décrit, de l'arséniure de gallium et d'aluminium (GaAlAs).

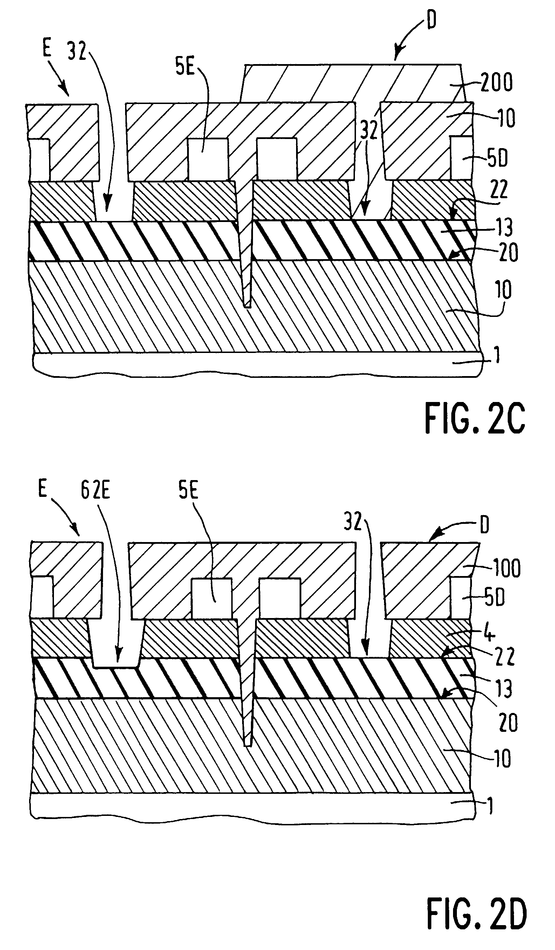

Selon le procédé conforme à l'invention, cette étape de gravure s'ARRETE AUTOMATIQUEMENT au niveau de la surface supérieure 22 de la couche sous-jacente 13 ou 14, grâce à la formation SYSTEMATIQUE d'une couche d'arrêt 3 de flurorure d'aluminium (AlF₃) par réaction de l'élément fluor (F) présent dans l'agent de gravure, sur l'élément aluminium (Al) present dans le matériau (GaAlAs) de cette couche sous-jacente 13 ou 14 ; l'épaisseur de cette couche d'arrêt formée en fluorure d'aluminium est en général une ou deux monocouches atomiques, c'est-à-dire 0,3 à 0,6 nm, donc environ 10 fois plus mince que la couche d'arrêt construite dans la structure du dispositif connu de l'état de la technique.
- En référence avec la FIG.2C, l'élimination de la couche d'arrêt 3 en fluorure d'aluminium (AlF₃), formée systématiquement dans l'étape précédente, par lavage au moyen d'une opération simple d'immersion de la plaquette support 1 (WAFER) dans l'eau ; aucun agent de gravure n'est nécessaire ; il en résulte l'apparition d'une surface 32 du matériau de la couche sous-jacente 13 ou 14 en arséniure de gallium et d'aluminium (GaAlAs) ;

Un autre avantage de l'invention est que la couche d'arrêt 3, dont la surface coïncidait avec celle de l'ouverture de grille, est maintenant éliminée. Le transistor terminé n'inclut donc pas de parties non éliminées de couches d'arrêt de gravure qui, quand elles subsistent créent des résistances parasites et des effets de piégeage, ou bien au contraire engendre des possibilités de claquages.
- En référence avec la FIG.2C, le recouvrement de la région du transistor à désertion D par une couche 200 d'un matériau d'un type de photorésist différent de la couche masque 100 préalablement réalisée. On sélectionne le matériau de la couche 200 parmi ceux qui peuvent être éliminés facilement sans que cette élimination détériore la couche sous-jacente 100. Par exemple, on pourra choisir comme matériau pour réaliser la couche 100 une laque PMMA ; et comme matériau pour réaliser la couche ultérieure 200, une photorésist positive ayant un agent de développement aqueux. De cette manière la couche 200 pourra être éliminée, au moment nécessaire, par exposition à la lumière puis développement en milieu aqueux sans endommager la couche 100 sous-jacente.
- En référence avec la FIG.2D, la gravure non sélective de l'évidement de grille 52E relatif au transistor à enrichissement E, à travers l'ouverture 51E dans la couche de photorésist 100, et 54E dans la couche chapeau 4. Cette gravure est menée à bien sur une profondeur égale à la différence de profondeur HE - HD = hE - hD qui doit exister entre les deux types de transistors D et E, dans le dispositif semiconducteur déterminé.

Cette gravure non sélective peut être mise en oeuvre par une méthode de gravure ionique réactive (RIE) avec un plasma incluant un agent de gravure sans fluor tel que Cl₂ ou BCl₃.

Dans une variante avantageuse, cette gravure non sélective peut être mise en oeuvre par voie humide, au moyen d'un mélange de H₃PO₄ ou H₃NO₄, plus H₂O₂, plus H₂O, dans les proportions 3 : 1 : 20. L'avantage est que les surfaces gravées obtenues sont nettes et non perturbées par le processus de gravure.

Cette étape mise en oeuvre par l'une ou l'autre des méthodes citées, permet une première localisation d'un niveau 62E intermédiaire dans la réalisation de l'évidement de grille 52E du transistor à enrichissement, par rapport à la surface supérieure 22 de la couche gravée 13 ou 14. Cette première localisation est précise du fait que cette surface 22 était marquée par la couche d'arrêt 3 et sert maintenant de repère pour le niveau de départ de cette gravure d'évidement de grille jusqu'à ce niveau intermédiaire 62E, et du fait que l'épaisseur à graver dans cette étape est toujours petite : un ordre de grandeur de cette épaisseur de gravure est environ 9 nm pour obtenir la différence de profondeur entre l'évidement du transistor à désertion D et l'évidement du transistor à enrichissement E.

L'homme du métier sait réaliser une telle étape de gravure avec la précision requise d'au plus quelques monocouches de matériau semiconducteur du fait que cette gravure part d'une surface 22 bien localisée, et du fait que l'épaisseur à graver est petite (moins de 10 nm). En effet le taux de gravure est connu avec une précision donnée par la concentration en agent de gravure ; et la profondeur de gravure est déterminée comme une fonction du taux de gravure pendant un temps donné. Ainsi l'erreur qui peut se produire sur cette faible épaisseur gravée, est elle-même extrêmement faible. D'autre part l'erreur qui peut se produire sur l'épaisseur gravée, d'une extrémité à l'autre de la plaquette support est faible puisque le repère de départ de gravure est le même sur toute la plaquette. Cette gravure est donc uniforme.
- En référence avec la FIG.2D, l'élimination du matériau de recouvrement 200 qui avait été déposé dans l'étape relative à la FIG.2D, sur les régions de transistors à désertion D.
- En référence avec la FIG.2E, la gravure non sélective par la méthode de gravure adoptée dans l'étape relative à la FIG.2D (RIE avec Cl₂ ou BCl₂ ; ou gravure humide avec H₃NO₄, plus H₂O₂ plus H₂O), d'une manière concomitante de l'évidement de grille 52D relatif au transistor à désertion D, et de l'évidement de grille 52E relatif au transistor à enrichissement E, à travers les ouvertures 51D et 51E dans la couche de photorésist 100, et 54D, 54E dans la couche chapeau 4.

Cette étape de gravure est menée à bien sur une profondeur d'environ 6 nm qui représente :
. la profondeur totale de l'évidement de grille du transistor à désertion D dans la couche active 13 ou 14,
. la profondeur nécessaire à atteindre la profondeur totale d'environ 15 nm de l'évidement de grille du transistor à enrichissement E dans la couche active 13 ou 14,
. lorsque cette couche active 13 ou 14, 15, 12 a une épaisseur de l'ordre de 50 nm pour l'exemple de réalisation de transistors HEMTs, ou HEMTs pseudomorphiques envisagée.

Dans cette étape de gravure, on localise directement le fond 42D de l'évidement de grille 52D du transistor à désertion à son niveau définitif à partir de la surface supérieure 22 de la couche gravée 13 ou 14. Cette étape de gravure est donc menée à bien, comme on l'a dit précédemment avec la précision requise d'au plus quelques monocouches de matériau semiconducteur du fait que cette gravure part de la surface 22 bien localisée et que l'épaisseur à graver est petite (≃ 6 nm).

Dans cette étape de gravure, de façon concomitante, on localise définitivement le fond 42E de l'évidement de grille 52E du transistor à enrichissement à partir du niveau intermédiaire 62E qui était déjà précisément localisé. Maintenant la précision sur la localisation du fond 42E est la même que celle obtenue pour la localisation du fond 42D de l'évidement 52D, puisque les gravures sont concomitantes. La précision reste dans la fourchette permise de quelques monocouches de matériau semiconducteur. Donc malgré la formation de l'évidement de grille du transistor E en deux étapes, avec une reprise de gravure entre les deux étapes, le fond 42E de cet évidement et très précisément localisé, parce que la profondeur gravée dans chacune des deux étapes part chaque fois d'un repère fixe : la première fois le repère est la surface 32 dans l'ouverture 51E ; et la seconde fois, le repère est la surface 32 dans l'ouverture 51D, la profondeur gravée pour le transistor E étant la même que pour le transistor D dans cette dernière étape de gravure, puisque les deux gravures sont menées à bien de manière concomitante. Donc la précision obtenue sur la localisation du fond 42D de l'évidement du transistor D entraîne la même précision pour la localisation du fond 42E du transistor E.

Il a été constaté qu'en mettant en oeuvre le procédé selon l'invention, la précision de l'ensemble (plusieurs milliers) des transistors des deux types réalisés sur une même plaquette est très homogène dans la fourchette de précision envisagée. Des test électriques peuvent être faits, dans le cours du processus de gravure pour vérifier des paramètres fonctions de l'épaisseur gravée.

Dans le cas où la gravure de l'évidement 52D, 52E a été faite par RIE, on prévoit éventuellement le traitement par voie humide (WET ETCHING) pour éliminer, sur un très petit nombre de monocouches, les contraintes et défauts produits dans cette étape de gravure sèche, au moyen d'un mélange H₃PO₄ ou H₃NO₄, plus H₂O₂ plus H₂O, dans les proportions 3 : 1 : 20. Ou bien encore, pour éliminer ces contraintes, on peut prévoir un recuit.
- En référence avec la FIG.1B, le dépôt d'une couche métallique 8E, 8D ; ce dépôt s'effectue à travers les ouvertures de grille 51D, 51E pour réaliser le plot métallique de grille 8D, 8E à la précision de cette ouverture de grille 51D, 51E et en contact avec les fonds 42D, 42E des évidements de grille ; ce dépôt s'effectue aussi en surface de la couche de photorésist 100 ; cette couche de photorésist 100 est ensuite éliminée par un procédé connu de LIFT-OFF, entraînant la portion de couche métallique autre que celle nécessaire aux plots de grille 8D, 8E.

## Revendications

1. Procédé de réalisation d'un dispositif semiconducteur incluant au moins deux transistors (D,E) à effet champ, du type à canal creusé, dont le premier (D) a un évidement de grille moins profond que l'autre (E), ce procédé comprenant :
- la réalisation d'un empilement de couches sur un substrat (1), parmi lesquelles au moins :
. une couche active (13, 14) en un composé semiconducteur incluant un taux d'aluminium (Al) non nul, dans laquelle un évidement de grille (52D, 52E) est à creuser,
. une couche chapeau (4) en un composé semiconducteur sans aluminium (Al),
. une couche de masquage (100) munie d'une ouverture dite ouverture de grille (51D,51E) pour chaque transistor (D,E),
- une première gravure sélective, avec un premier agent de gravure composé du fluor (F) pratiquée dans la couche chapeau (4), à travers les ouvertures de grille (51D, 51E) des deux transistors, et jusqu'à formation, à la surface supérieure (22) de la couche active (13, 14), d'une couche d'arrêt (3) en fluorure d'aluminium (AlF₃), puis l'élimination de cette couche d'arrêt (3), et le recouvrement, au moyen d'un matériau (200) pouvant être éliminé sans détérioration de la couche de masquage (100) précédemment déposée, de la région du premier transistor (D),
- une seconde gravure non sélective pratiquée dans la couche active (13, 14), avec un second agent de gravure, à travers l'ouverture de grille (51E) jusqu'à un niveau intermédiaire (62E) de l'évidement de grille du second transistor (E), à une profondeur égale à la différence des profondeurs des évidements de grille (52D, 52E) des deux transistors, et l'élimination du matériau de recouvrement (200),
- une troisième gravure non sélective pratiquée dans la couche active (13, 14), de manière concomitante à travers les deux ouvertures de grille (51D, 51E) des deux transistors (D,E) jusqu'au niveau du fond de l'évidement de grille du premier transistor (D).

2. Procédé selon la revendication 1, caractérisé en ce que la première gravure sélective est pratiquée par gravure ionique réactive (RIE) à l'aide d'un plasma incluant un composé du fluor qui peut être C₂Cl₂F₂ ou une association de SiCl₄ et SF₆.

3. Procédé selon l'une des revendications 1 ou 2, caractérisé en ce que la seconde et la troisième gravures non sélectives sont pratiquées par gravure ionique réactive (RIE) à l'aide d'un plasma incluant un composé sans fluor qui peut comprendre Cl₂ ou BCl₃.

4. Procédé selon la revendication 3, caractérisé en ce qu'il comprend un traitement final après les gravures pour éliminer les contraintes et défauts superficiels des surfaces gravées par RIE, au moyen d'un mélange H₃ PO₄ ou bien H₃ NO₄, avec H₂O₂ et H₂O, dans les proportions 3 : 1 : 20.

5. Procédé selon l'une des revendications 1 ou 2, caractérisé en ce que la seconde et la troisième gravures non sélectives sont pratiquées par voie humide avec un agent de gravure composé sans fluor, tel que, par exemple, un mélange de H₃PO₄ ou bien H₃NO₄, avec H₂O₂ et H₂O dans les proportions respectives 3 : 1 : 20.

6. Procédé selon l'une des revendications 1 à 5, caractérisé en ce que :
. l'élimination de la couche d'arrêt (3) en fluorure d'aluminium est faite par lavage à l'eau (H₂O).

7. Procédé selon l'une des revendications 1 à 6, caractérisé en ce que, pour former un transistor à effet de champ à haute mobilité électronique (HEMT), l'empilement de couches semiconductrices à partir du substrat (1) comprend au moins successivement :
- une première couche active (10) en un composé semiconducteur de petite largeur de bande interdite,
- une seconde couche active (13) en un composé semiconducteur incluant un taux non nul d'aluminium, de plus grande largeur de bande interdite et fortement dopée pour former une hétérostructure d'interface (20) avec la première couche (10), seconde couche dans laquelle les évidements (52D, 52E) de grille sont formés pour recevoir des contacts Schottky de grille (8D, 8E), la distance entre le fond (42D, 42E) de ces évidements et l'interface (20) de l'hétérostructure étant strictement contrôlée pour la réalisation, de deux transistors ayant des tensions de pincement différentes tels qu'un transistor à désertion D, et un transistor à enrichissement E, qui sont les deux transistors ayant des évidements de grille de profondeurs différentes,
- la couche chapeau (4) fortement dopée pour recevoir les contacts ohmiques (5D, 5E) pour chaque transistor (D,E).

8. Procédé selon l'une des revendications 1 à 6, caractérisé en ce que, pour former un transistor à effet de champ à haute mobilité électronique (HEMT) pseudomorphique, l'empilement de couches semiconductrices à partir du substrat comprend :
- une couche dite tampon (10), non dopée intentionnellement en un composé semiconducteur de faible largeur de bande interdite,
- une couche dite canal (11), non dopée intentionnellement en un composé semiconducteur de faible largeur de bande interdite,
- une couche dite espaceur (12) non dopée intentionnellement en un composé semiconducteur de grande largeur de bande interdite formant une hétérostructure avec la couche sous-jacente de faible largeur de bande interdite,
- une couche dite donneur (15) fortement dopée, en un composé semiconducteur de grande largeur de bande interdite,
- une couche dite Schottky (14), non dopée intentionnellement incluant un taux d'aluminium non nul, de grande largeur de bande interdite dans laquelle les évidements (52D, 52E) de grille sont formés pour recevoir des contacts Schottky (8D, 8E) de grille, la distance entre le fond (42D, 42E) de ces évidements et l'interface (20) de l'hétérostructure étant strictement contrôlé pour la réalisation de deux transistors ayant des tensions de pincement différentes tels qu'un transistor à désertion (D), et un transistor à enrichissement (E), qui sont les deux transistors ayant des évidements de grille de profondeurs différentes,
- la couche chapeau (4) fortement dopée pour recevoir les contacts ohmiques de source et drain (5D, 5E) pour chaque transistor (D,E).

9. Procédé selon l'une des revendications 7 ou 8, caractérisé en ce que le composé semiconducteur de faible largeur de bande interdite est de l'arséniure de gallium (GaAs), ou de l'arséniure de gallium et d'indium (GaInAs), en ce que le composé semiconducteur de grande largeur de bande interdite est l'arséniure de gallium et d'aluminium (GaAlAs) et en ce que le substrat et la couche chapeau sont en arséniure de gallium (GaAs).

## Claims

1. A method of manufacturing a semiconductor device comprising at least two field effect transistors (D, E) of the buried channel type of which the first (D) has a gate recess which is less deep than that of the other (E), which method comprises:
- the realisation of a stack of layers on a substrate (1), among which at least:
. an active layer (13, 14) of a semiconductor compound having a non-zero aluminium (Al) content, in which a gate recess (52D, 52E) is to be provided,
. a cap layer (4) of a semiconductor compound without aluminium (Al),
. a masking layer (100) provided with a gate opening (51D, 51E) for each transistor (D, E),
- a first selective etching step with a first etching compound comprising fluorine (F) carried out in the cap layer (4) through the gate openings (51D, 51E) of the two transistors until a stopper layer (3) of aluminium fluoride (AlF₃) is formed at the upper surface (22) of the active layer (13, 14), after which said stopper layer (3) is eliminated, and the region of the first transistor (D) is covered with a material (200) which can be eliminated without deterioration of the masking layer (100) previously deposited,
- a second non-selective etching step carried out in the active layer (13, 14), with a second etchant, through the gate opening (51E) down to an intermediate level (62E) of the gate recess of the second transistor (E), to a depth equal to the difference in depth between the gate recesses (52D, 52E) of the two transistors, followed by removal of the covering material (200),
- a third non-selective etching step carried out in the active layer (13, 14) simultaneously through the two gate openings (51D, 51E) of the two transistors (D, E) down to the bottom level of the gate recess of the first transistor (D).

2. A method as claimed in claim 1, characterized in that the first selective etching step is carried out by reactive ion etching (RIE) by means of a plasma comprising a fluorine compound which may be C₂Cl₂F₂ or a mixture of SiCl₄ and SF₆.

3. A method as claimed in any one of claims 1 and 2, characterized in that the second and the third non-selective etching steps are carried out by reactive ion etching (RIE) by means of a plasma comprising a compound without fluorine, which may comprise Cl₂ or BCl₃.

4. A method as claimed in claim 3, characterized in that it comprises a final treatment after the etching steps for eliminating surface stresses and defects of the surfaces etched by RIE by means of a mixture of H₃PO₄ or H₃NO₄ with H₂O₂ and H₂O in the proportions 3:1:20.

5. A method as claimed in any one of claims 1 and 2, characterized in that the second and the third non-selective etching steps are carried out in a wet process with an etching compound without fluorine such as, for example, a mixture of H₃PO₄ or H₃NO₄ with H₂O₂ and H₂O in respective proportions of 3:1:20.

6. A method as claimed in any one of claims 1 to 5, characterized in that:
. the removal of the stopper layer (3) of aluminium fluoride is carried out through washing with water (H₂O).

7. A method as claimed in any one of claims 1 to 6, characterized in that, for forming a high electron mobility field effect transistor (HEMT), the stack of semiconductor layers starting from the substrate (1) comprises at least, in this order:
- a first active layer (10) of a semiconductor compound of small forbidden bandwidth,
- a second active layer (13) of a semiconductor compound having a non-zero aluminium content, of a greater forbidden bandwidth, and strongly doped for forming a heterostructure interface (20) with the first layer (10), in which second layer the gate recesses (52D, 52E) are formed for accommodating Schottky gate contacts (8D, 8E), the distance between the bottoms (42D, 42E) of these recesses and the interface (20) of the heterostructure being strictly controlled for the manufacture of two transistors having different pinch-off voltages, such as a depletion-type transistor D and an enhancement-type transistor E, which are the two transistors having gate recesses of different depths,
- the strongly doped cap layer (4) for accommodating the respective ohmic contacts (5D, 5E) for each transistor (D, E).

8. A method as claimed in any one of claims 1 to 6, characterized in that, for forming a pseudomorphic high electron mobility field effect transistor (HEMT), the stack of semiconductor layers starting from the substrate comprises:
- a buffer layer (10) which is not intentionally doped and is made of a semiconductor compound of small forbidden bandwidth,
- a channel layer (11) which is not intentionally doped and is made of a semiconductor compound of small forbidden bandwidth,
- a spacer layer (12) which is not intentionally doped and is made of a semiconductor compound of great forbidden bandwidth, forming a heterostructure with the subjacent layer of small forbidden bandwidth,
- a carrier supplying layer (15) which is strongly doped and is made of a semiconductor compound of great forbidden bandwidth,
- a Schottky layer (14) which is not intentionally doped and has a non-zero aluminium content, of great forbidden bandwidth, in which the gate recesses (52D, 52E) are formed for accommodating Schottky gate contacts (8D, 8E), the distance between the bottoms (42D, 42E) of these recesses and the interface (20) of the heterostructure being strictly controlled for the realisation of two transistors having different pinch-off voltages, such as a depletion-type transistor (D) and an enhancement-type transistor (E), which are the two transistors having gate recesses of different depths,
- the strongly doped cap layer (4) for accommodating the ohmic source and drain contacts (5D, 5E) for each transistor (D, E).

9. A method as claimed in any one of claims 7 and 8, characterized in that the semiconductor compound of small forbidden bandwidth is gallium arsenide (GaAs) or gallium-indium arsenide (GaInAs), the semiconductor compound of great forbidden bandwidth is gallium-aluminium arsenide (GaAlAs), and the substrate and the cap layer are made of gallium arsenide (GaAs).

## Patentansprüche

1. Herstellungsverfahren für eine Halbleiteranordnung mit wenigstens zwei Feldeffekttransistoren (D, E) mit vertieftem Kanal, von denen der erste (D) eine wenigertiefe Gate-Aussparung hat als der zweite (E), wobei das Verfahren folgendes umfaßt:
- die Herstellung einer ersten Stapelung von Schichten auf einem Substrat (1), mit wenigstens:
. einer aktiven Schicht (13, 14) aus einer Halbleiterverbindung mit einem Aluminiumgehalt (Al) ungleich null, in der eine Gate-Aussparung (52D, 52E) einzugraben ist,
. einer Deckschicht (4) aus einer aluminiumfreien Halbleiterverbindung (Al),
. einer Maskierungsschicht (100), die für jeden Transistor (D, E) mit einer sogenannten Gate-Öffnung (51D, 51E) versehen ist,
- eine erste selektive Ätzung mit einem ersten, aus Fluor (F) bestehenden Ätzmittel, die in der Deckschicht (4) vorgenommen wird, und zwar durch die Gate-Öffnungen (51D, 51E) der beiden Transistoren und bis zur Bildung einer Sperrschicht (3) aus Aluminiumfluorid (AlF₃) auf der Oberseite (22) der aktiven Schicht (13, 14) und einer anschließenden Entfernung dieser Sperrschicht (3) und der Bedeckung mit einem Material (200), das ohne Beeinträchtigung der zuvor aufgebrachten Maskierungsschicht (100) von dem Gebiet des ersten Transistors (D) entfernt werden kann,
- eine zweite, nicht-selektive Ätzung, die in der aktiven Schicht (13, 14) mit einem zweiten Ätzmittel vorgenommen wird, und zwar durch die Gate-Öffnung (51E) bis auf eine Zwischenebene (62E) der Gate-Aussparung des zweiten Transistors (E) auf einer Tiefe, die gleich der Differenz der Tiefen der Gate-Aussparungen (52D, 52E) dieser beiden Transistoren ist, und der Entfernung des Deckmaterials (200),
- eine dritte, nicht-selektive Ätzung, die in der aktiven Schicht (13, 14) gleichzeitig durch die beiden Gate-Öffnungen (51D, 51E) der beiden Transistoren (D, E) bis auf die Ebene des Bodens der Gate-Aussparung des ersten Transistors (D) vorgenommen wird.

2. Verfahren nach Anspruch 1, dadurch gekennzeichnet, daß die erste selektive Ätzung durch reaktive Ionenätzung (RIE) mit Hilfe eines Plasmas durchgeführt wird, das eine Fluorverbindung wie beispielsweise C₂Cl₂F₂ oder eine Kombination von SiCl₄ und SF₆ darstellt.

3. Verfahren nach Anspruch 1 oder 2, dadurch gekennzeichnet, daß die zweite und dritte nicht-selektive Ätzung durch reaktive Ionenätzung (RIE) mit Hilfe eines Plasmas durchgeführt wird, das eine fluorfreie Verbindung enthält und Cl₂ oder BCl₃ enthalten kann.

4. Verfahren nach Anspruch 3, dadurch gekennzeichnet, daß es eine abschließende Behandlung nach den Ätzungen umfaßt, um die Oberflächenmängel und -fehler der durch RIE geätzten Flächen mit Hilfe einer Mischung aus H₃PO₄ oder H₃NO₄ mit H₂O₂ und H₂O im Verhältnis 3 : 1 : 20 zu beseitigen.

5. Verfahren nach Anspruch 1 oder 2, dadurch gekennzeichnet, daß die zweite und dritte nicht-selektive Ätzung in nasser Weise durchgeführt werden, und zwar mit einer fluorfreien Ätzmittelverbindung wie beispielsweise einer Mischung von H₃PO₄ oder H₃NO₄ mit H₂O₂ und H₂O im Verhältnis 3 : 1 : 20.

6. Verfahren nach einem der Ansprüche 1 bis 6, dadurch gekennzeichnet, daß
. die Beseitigung der Sperrschicht (3) aus Aluminiumfluorid durch Waschung mit Wasser (H₂O) erfolgt.

7. Verfahren nach einem der Ansprüche 1 bis 6, dadurch gekennzeichnet, daß zur Herstellung eines Feldeffekttransistors mit hoher Elektronenbeweglichkeit (HEMT), die Stapelung der Halbleiterschichten vom Substrat (1) aus nacheinander mindestens folgendes umfaßt:
- eine erste aktive Schicht (10) aus einer Halbleiterverbindung mit geringem Bandabstand,
- eine zweite aktive Schicht (13) aus einer Halbleiterverbindung mit einem Aluminiumgehalt ungleich null, mit einem größeren Bandabstand und starker Dotierung zur Bildung eines Heterostrukturübergangs (20) mit der ersten Schicht (10), wobei die Gate-Öffnungen (52D, 52E) in der zweiten Schicht so hergestellt sind, daß sie Schottky-Gate-Kontakte (8D, 8E) aufnehmen, und der Abstand zwischen dem Boden (42D, 42E) dieser Öffnungen und dem Übergang (20) der Heterostruktur genau überwacht wird, um zwei Transistoren herzustellen, die unterschiedliche Pinch-Spannungen haben als ein Verarmungstransistor D und ein Anreicherungstransistor E und die die beiden Transistoren mit Gate-Aussparungen unterschiedlicher Tiefe darstellen,
- die stark dotierte Deckschicht (4) zur Aufnahme der ohmschen Kontakte (5D, 5E) für jeden Transistor (D, E).

8. Verfahren nach einem der Ansprüche 1 bis 6, dadurch gekennzeichnet, daß zur Herstellung eines pseudomorphen Feldeffekttransistors mit hoher Elektronenbeweglichkeit (HEMT) die Stapelung der Halbleiterschichter auf dem Substrat folgendes umfaßt:
- eine absichtlich nicht-dotierte sogenannte Pufferschicht (10) aus einer Halbleiterverbindung mit geringem Bandabstand,
- eine abschichtlich nicht-dotierte sogenannte Kanalschicht (11) aus einer Halbleiterverbindung mit geringem Bandabstand,
- eine abschichtlich nicht-dotierte sogenannte Abstandsschicht (12) aus einer Halbleiterverbindung mit großem Bandabstand, die eine Heterostruktur mit der unterliegenden Schicht mit geringem Bandabstand bildet,
- eine stark dotierte sogenannte Spenderschicht (15) aus einer Halbleiterverbindung mit großem Bandabstand,
- eine absichtlich nicht-dotierte sogenannte Schottky-Schicht (14) mit einem Aluminiumgehalt ungleich null und großem Bandabstand, in der der Gate-Aussparungen (52D, 52E) so hergestellt sind, daß sie Schottky-Gate-Kontakte (8D, 8E) aufnehmen, wobei der Abstand zwischen dem Boden (42D, 42E) dieser Aussparungen und dem Übergang (20) der Heterostruktur genau überwacht wird, um zwei Transistoren herzustellen, die unterschiedliche Pinch-Spannungen haben als ein Verarmungstransistor D und ein Anreicherungstransistor E und die die beiden Transistoren mit Gate-Aussparungen unterschiedlicher Tiefe darstellen,
- die stark dotierte Deckschicht (4) zur Aufnahme der ohmschen Kontakte (5D, 5E) für jeden Transistor (D, E).

9. Verfahren nach Anspruch 7 oder 8, dadurch gekennzeichnet, daß die Halbleiterverbindung mit geringem Bandabstand aus Galliumarsenid (GaAs) oder aus Gallium-Indiumarsenid (GaInAs), die Halbleiterverbindung mit großem Bandabstand aus Gallium-Aluminiumarsenid (GaAlAs) und das Substrat und die Deckschicht aus Galliumarsenid (GaAs) bestehen.
